# EUROPEAN PATENT APPLICATION

(11) **EP 0 672 762 A1**
(43) Date of publication of application: **20.09.1995**
(21) Application number: 95830101.2
(22) Date of filing: 17.03.1995
(51) Int. Cl.: C23C 14/56

(54) **Apparatus for continuous vacuum metallization**

(30) Priority: 18.03.1994 IT FI940054
(71) Applicant: GALILEO VACUUM TEC S.p.A., I-50013 Campi Bisenzio (FI) (IT)
(72) Inventor: Grazzini, Franco, I-50134 Firenze (IT)
(74) Representative: Mannucci, Gianfranco, Dott.-Ing.

(57) **Abstract**

Intermediate redirecting rollers (5, 7, 9) define two sections (N1, N2) in the path of the material lying in basically symmetrical, upwardly-converging and inclined planes, the evaporators (1) being located beneath the said path sections.

## Description

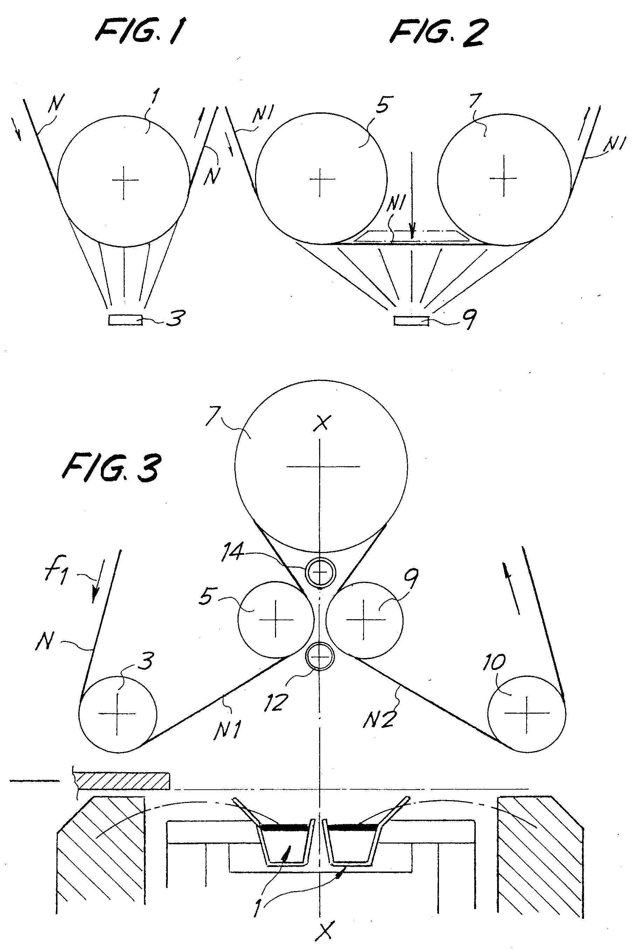

In traditional plant for depositing a vapour of any type of substance (Al, SiO, or the like) under vacuum on a strip, a cooled processing roller 01 (Fig. 1) is provided around which the strip N travels, the strip or film being subjected to the treatment produced by the evaporators 03 as it passes around the roller. In other designs employing the free-span configuration, the strip N1 does not rest on a cooled processing roller, but passes freely over the evaporation area (Fig. 2) lying between two rollers 05 and 07; evaporators 09 are located beneath the path situated between the two rollers 05 and 07. In the case of strips or films made from materials which are not particularly degassing and/or are very heat resistant and/or are extremely thick, this arrangement is possible and is the one used. Nevertheless, it is necessary to remedy the problem of degassing from the back face of the material - which is especially hot since it is not in contact with cooling rollers - by using special pumping units supplemented with cryogenic panels which condense the vapours.

The advantage of so-called free-span designs according to the arrangement shown in Fig. 2 is that they give a greater evaporation yield (approximately 10%), since the surface area of the material covered by the evaporation area can be increased given the same distance between the evaporators and the material. The angles of incidence of the vapour are better than those obtained using the conventional arrangement shown in Fig. 1.

The invention relates to a version which improves on the arrangement shown in Fig. 2.

Basically - according to the invention - a continuous plant for metallization under vacuum, of the type having two rollers which delimit a treatment area along the path of the material between the two rollers, comprises additional intermediate redirecting roller means which define two sections in the path of the material lying in upwardly-converging and inclined planes, the evaporators being located beneath the said path sections.

The two path sections can be basically symmetrical.

The plant advantageously comprises at least one intermediate redirecting roller, which is also a cooling roller.

The plant comprises at least one roller which redirects the material from one of the path sections towards the redirecting and cooling roller, in order to shield the said cooling roller from the vapours emitted.

In one possible version, the cooling roller is in an asymmetrical position with respect to the planes in which the two path sections lie.

In another possible version, two redirecting rollers are provided between the two path sections, which rollers flank the cooling roller; the layout can be basically symmetrical.

The plant can comprise evaporators located in two rows, with the evaporators in each row being inclined upwards and towards those of the other row, so that their orientation with respect to the path sections is improved.

In conclusion, the version according to the invention optimizes the plant since the evaporating area is more enclosed than in known versions, causing the material to pass in a "tent" shape over the evaporators. The condensing surface is longer, reducing the specific thermal load. The angles of incidence are better. The evaporation yield is increased by up to some 25%. The cooling redirecting roller enables intermediate cooling to take place, which is not possible in the typical known version employing a free-span configuration.

The version in which the cooled roller is asymmetrical enables it to be effectively shielded from the vapours of the material itself.

In principle, a plurality of intermediate cooling redirecting rollers can be provided.

The invention will be more clearly understood after reading the description and examining the appended drawing which shows a practical and a non-limiting example of the said invention. In the drawing:
Figs. 1 and 2 show two conventional arrangements which have already been discussed;
Fig. 3 shows an arrangement according to the invention with a symmetrical layout;
Fig. 4 shows another arrangement according to the invention with an asymmetrical layout; and
Fig. 5 shows a variant with a layout in which the evaporators are inclined.

According to the illustrations in the appended drawing and with reference to Fig. 3, the numeral 1 diagrammatically indicates evaporators located - according to the drawing - in a single row or in two rows, in a position symmetrical with respect to a plane of symmetry having a vertical axis marked X-X. The strip or film N is redirected by a first roller 3 as far as a second roller 5 in order to create a first active section N1 in the path of the material to be treated. The numeral 7 indicates an intermediate redirecting roller which is also a roller for cooling the material; the material is thus redirected as far as a second redirecting roller 9, which is symmetrical with the roller 5 with respect to the axis X-X, from which roller 9 the material is redirected in order to create a second active path section N2, as far as an additional redirecting roller 10 which is symmetrical with the roller 3 with respect to the axis X-X. The two path sections N1 and N2 are inclined towards each other and upwards, in a position which is symmetrical with respect to the evaporators 1, i.e. in a configuration which can be described as "tent" shaped.

The redirecting rollers 5 and 9 can also be cooling rollers, replacing or combining with the roller 7.

The numerals 12 and 14 indicate shields which, together with the basically close positioning of the two redirecting rollers 5 and 9, are able to prevent or limit the possibility of emissions from the evaporators 1 reaching the exposed surface of the roller 7.

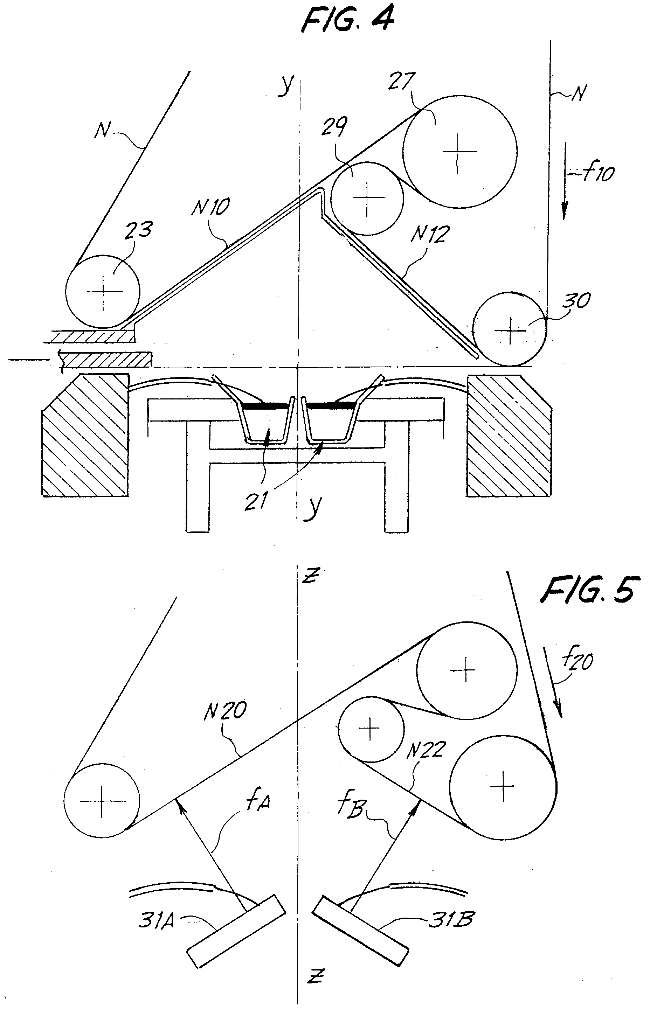

The diagram of Fig. 4 shows a layout similar to that of Fig. 3 as far as forming the "tent" shaped travel of the two active path sections is concerned, but with a layout which differs from the symmetrical one shown in Fig. 3. The numeral 21 indicates the evaporators; 23 indicates a roller - optionally cooled - for redirecting the material N; N10 and N12 indicate two active path sections which are inclined towards each other and upwards; 27 indicates a main cooling and redirecting roller; 29 indicates a second redirecting, and optionally cooling, roller; and 30 indicates an additional roller for redirecting the strip or film material N. The direction of advance of the material can be that indicated by the arrow f10 towards the roller 30 or can be in the opposite direction. In this layout, one of the two path sections (according to the drawing, that marked N10) is extended beyond the centre line of the area of activity of the evaporators, which line is indicated by the line Y-Y of a vertical axial plane of the layout of the evaporators, in order to reach the redirecting and cooling roller 27, which is a very short distance from the redirecting roller 29. With this layout, the possibility of the emissions from the evaporators 21 reaching the exposed surface of the roller 27 is further reduced, even without having recourse to shields of the type indicated by the numerals 12 and 14 in Fig. 3.

The evaporators can be located in a single row or in two rows which are symmetrical with respect to the planes of symmetry marked by the lines X-X or Y-Y. These evaporators in the two rows can both have a horizontal layout, i.e. a coplanar layout, or they can have a mutual and symmetrical inclination in order to improve the orientation of the lobes of emission of the said evaporators with respect to the active path sections such as the sections N1, N2 and N10, N12. According to the illustration of Fig. 5, which is a variant of the version shown in Fig. 4 - but which is also valid for other versions such as that shown in Fig. 3 or equivalent versions - the evaporators 31A and 31B, which are located along two adjacent rows symmetrical with respect to a vertical plane of symmetry marked Z-Z, are inclined towards one another and upwards so that the predominant direction of emissions therefrom is in the direction of the arrows fA and fB, giving better orientation with respect to the travel of the active path sections indicated in Fig. 5 by N20 and N22. The inclination of the evaporators such as those 31A and 31B with respect to the horizontal will be contained within the range of angular values which proves most suited to distribution over the vaporization surfaces of the evaporators in relation to the possibility of distribution of the liquefied metal, for example aluminium, fed in the form of a wire which is made to advance gradually towards the highest area of the respective evaporators, on a principle which is known per se in the field of vacuum metallizations.

Using the layout with mutually inclined path sections, the advantages already mentioned, together with others which will be evident to experts in the field, are achieved.

It will be understood that the drawing shows only an illustrative embodiment, given solely by way of practical demonstration, of the invention, it being possible for the said invention to vary in shape and layout without thereby departing from the scope of the underlying concept of the invention.

## Claims

1. Continuous plant for metallization under vacuum, of the type having two rollers which delimit a treatment area along the path of the material between the two rollers, characterized in that it comprises additional intermediate redirecting roller means which define two sections in the path of the material lying in upwardly-converging and inclined planes, the evaporators being located beneath the said path sections.

2. Plant according to Claim 1, characterized in that the said two path sections are basically symmetrical.

3. Plant according to Claim 1 or 2, characterized in that it comprises at least one intermediate redirecting roller, which is also a cooling roller.

4. Plant according to Claim 3, characterized in that it comprises at least one roller which redirects the material from the first path section towards the redirecting and cooling roller, in order to shield the cooling roller from the vapours emitted.

5. Plant according to at least one of the preceding claims, characterized in that the cooling roller is in an asymmetrical position with respect to the planes in which the two path sections lie.

6. Plant according to Claim 4, characterized in that it comprises two symmetrical redirecting rollers between the two path sections, which rollers flank the cooling roller.

7. Plant according to Claim 6, characterized in that the layout of the cooling roller and of the two redirecting rollers is basically symmetrical.

8. Plant according to at least one of the preceding claims, characterized in that it comprises evaporators located in two rows, the evaporators in each row being inclined upwards and towards those of the other row.
